(19) Europäisches Patentamt
European Patent Office
Office européen des brevets

(11) Numéro de publication: **0 297 338 B1**

(12) **FASCICULE DE BREVET EUROPEEN**

(45) Date de publication du fascicule du brevet:
**24.07.91 Bulletin 91/30**

(51) Int. Cl.⁵ : **G01C 19/64**

(21) Numéro de dépôt: **88109380.1**

(22) Date de dépôt: **13.06.88**

(54) **Système interférométrique à fibre optique de type sagnac.**

(30) Priorité : **11.06.87 FR 8708135**

(43) Date de publication de la demande :
**04.01.89 Bulletin 89/01**

(45) Mention de la délivrance du brevet :
**24.07.91 Bulletin 91/30**

(84) Etats contractants désignés :
**BE CH DE ES FR GB IT LI LU NL SE**

(56) Documents cités :
**EP-A- 0 206 866**

(73) Titulaire : **GEC ALSTHOM SA**
**38, avenue Kléber**
**F-75116 Paris (FR)**

(72) Inventeur : **Dupraz, Jean-Pierre**
**7 rue de la Paix**
**F-73100 Aix Les Bains (FR)**

(74) Mandataire : **Weinmiller, Jürgen et al**
**Lennéstrasse 9 Postfach 24**
**W-8133 Feldafing (DE)**

EP 0 297 338 B1

## Description

La présente invention concerne les systèmes interférométriques de type Sagnac employés en gyrométrie.

Ces systèmes interférométriques utilisent deux faisceaux lumineux issus d'une même source, généralement une diode de type laser, parcourant en sens opposés un même chemin optique constitué d'une fibre optique monomode avant d'interférer sur un photodétecteur. Ils permettent de mettre en évidence les modifications de phase non réciproques qui dépendent des sens de propagation des faisceaux et qui sont dues soit à l'effet Sagnac dans le cas de la gyrométrie soit à l'effet Faraday dans le cas de la mesure de courant, cela au détriment des modifications de phase réciproques qui sont dues aux différentes perturbations rencontrées par les faisceaux au cours de leur cheminement dans l'anneau interférométrique et qui s'éliminent par compensation au niveau du photodétecteur.

Sans disposition particulière, la puissance optique des deux faisceaux au niveau du photodétecteur présente une composante continue et une composante proportionnelle au cosinus de leur déphasage relatif ce qui a l'inconvénient de donner au photodétecteur une loi de détection cosinoïdale avec une sensibilité nulle à l'origine. Pour éliminer cet inconvénient, il est habituel d'imposer aux deux faisceaux circulant dans l'anneau interférométrique, une modulation de phase périodique et symétrique avec une périodicité double $2\tau$ du temps $\tau$ mis par les faisceaux pour parcourir l'anneau interférométrique. Cette modulation de phase permet d'obtenir, au niveau du photodétecteur, comme décrit dans la demande de brevet français FR-A-2.471.583, un signal présentant une composante de fréquence $1/2\tau$ qui est proportionnelle au sinus du déphasage relatif des deux faisceaux et pour laquelle la sensibilité est maximale à l'origine, dans la plage des petits déphasages relatifs.

Les systèmes interférométriques de type de Sagnac employés en gyrométrie ou pour la mesure de courant par effet Faraday outre le fait qu'ils utilisent une modulation de phase des faisceaux lumineux comportent, en règle générale, un coupleur en Y en optique intégrée réalisant la séparation de l'onde lumineuse de la source en deux faisceaux avant son entrée dans la fibre optique constituant l'anneau interférométrique et la recombinaison des deux faisceaux en sortie de l'anneau interférométrique, et un coupleur directif réalisant la séparation de l'onde lumineuse issue de la source et des deux faisceaux de retour de l'anneau interférométrique.

Ces dispositifs en optique intégrée qui s'imposent par rapport aux solutions de l'optique classique en raison de leurs avantages : insensibilité aux vibrations, faible encombrement..., ont l'inconvénient d'avoir des coefficients d'absorption non négligeables et d'être relativement difficiles à réaliser. C'est pourquoi, on a déjà proposé, notamment dans la demande de brevet français FR-A-2.582.800, de supprimer le coupleur directif en combinant la source lumineuse et le photodétecteur de manière à les rendre colinéaires, soit que l'un et l'autre soient réalisés au moyen d'une unique diode semi-conductrice utilisée alternativement en émetteur et en détecteur d'énergie lumineuse soit que l'un et l'autre soient alignés, la source lumineuse étant constituée d'une diode semi-conductrice couplée par ses faces avant et arrière, intercalée entre le photodétecteur et le coupleur en Y, et utilisée alternativement en émetteur et en amplificateur d'énergie lumineuse.

Dans les deux cas, la diode semi-conductrice est commutée de façon à émettre périodiquement des impulsions lumineuses les plus longues possibles c'est-à-dire de durée juste inférieure au temps $\tau'$ de propagation des deux faisceaux sur l'ensemble de leur trajet aller et retour. La période de commutation $2\tau'$ est alors très proche de celle $2\tau$ de la modulation de phase utilisée pour optimiser la sensiblité de détection car le parcours aller et retour effectué par les faisceaux entre la source lumineuse et la boucle interférométrique est petit par rapport à celui de la boucle interférométrique elle-même. Il en résulte dans le signal de sortie du photodétecteur, un recouvrement des diverses composantes dues à la modulation provenant de la commutation de la source et à la modulation de phase qui rend difficile la détection du signal utile.

Dans la demande de brevet français FR-A-2.582.800 précitée, cette difficulté est tournée en doublant artificiellement le temps de propagation des deux faisceaux sur leur trajet aller et retour par adjonction, entre la source et le coupleur en Y, d'une longueur supplémentaire de fibre optique égale au quart de la longueur de celle formant la boucle interférométrique.

La présente invention a pour but de résoudre le problème précité sans adjonction d'une longueur significative de fibre optique pour ne pas augmenter l'encombrement du système interférométrique ni amoindrir le rendement énergétique lumineux.

Elle a pour objet un système interférométrique à fibre optique de type Sagnac selon la revendication 1.

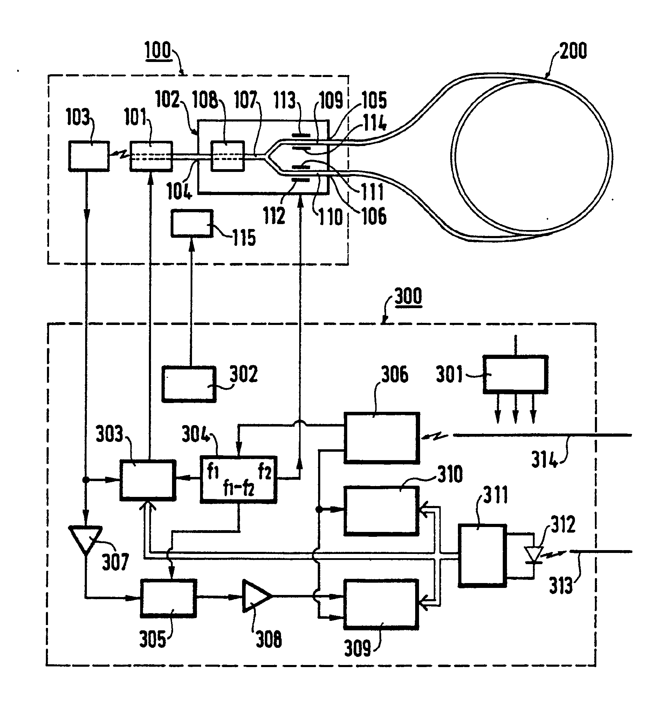

D'autres avantages de l'invention ressortiront de la description ci-après d'un mode de réalisaton donné à titre d'exemple. Cette description sera faite en regard du dessin dont la figure unique représente le schéma de principe de la partie optique et de la partie électronique d'un système d'interférométrique de Sagnac selon l'invention.

Le système interférométrique représenté comporte une platine optique 100 raccordée aux deux extrémités d'une fibre optique monomode 200 constituant un anneau interférométrique et à une platine électronique 300.

La platine optique 100 comporte une diode laser 101 émettant par ses faces avant et arrière, couplée par

2

sa face avant à un circuit en technologie optique intégrée 102 assurant les fonctions de polariseur, de filtre de mode, de coupleur en Y et de modulateur de phase, et par sa face arrière à un photodétecteur 103.

Le circuit en optique intégrée 102 est réalisé classiquement au moyen d'un substrat électro-optique portant des guides solides de lumière disposés en Y et des électrodes entre lesquelles peut se développer un champ électrique. Il possède un port d'entrée-sortie commun 104 qui est couplé à la face avant de la diode laser 101 et deux ports d'entrée-sortie de dérivation 105, 106 couplés aux extrémités de la fibre optique 200 constituant l'anneau interférométrique. Le port d'entrée-sortie commun 104 constitue l'extrémité d'un guide solide lumière monomode 107 à maintien de polarisation transformé en polariseur dans la région 108 par une technique classique de dopage par échange protonique ou de dépôt métallique. Ce guide solide de lumière 107 mène à une jonction en Y avec deux autres guides solides de lumière 109 et 110 monomodes à maintien de polarisation aboutissant aux ports d'entrée-sortie de dérivation 105 et 106.

La jonction assure un partage équilibré de l'énergie lumineuse lui parvenant par le guide solide de lumière 107 entre les deux guides de lumière 109 et 110 qui passent chacun entre une paire d'électrodes 111, 112, 113, 114 entre lesquelles on peut développer un champ électrique modifiant localement l'indice de réfraction du matériau optique pour moduler en phase les faisceaux lumineux.

La fibre optique monomode 200 constituant l'anneau interférométrique est soit une fibre optique monomode à maintien de polarisation dans le cas d'une gyromètre ou l'effet Sagnac est mis en oeuvre dans un anneau interférométrique parcouru par des faisceaux lumineux contrapropagatifs à polarisation linéaire, soit une fibre optique monomode à très forte biréfringence circulaire avec des boucles d'extrémités jouant le rôle de filtres quart d'onde dans le cas d'une mesure de courant où l'effet Faraday est mis en oeuvre dans une anneau interférométrique parcouru par des faisceaux lumineux contrapropagatifs à polarisation circulaire.

Dans ce montage optique, l'onde lumineuse émise sur la face avant de la diode laser 101 pénètre dans le circuit en optique intégrée 102 par le port entrée-sortie commun 104, subit un filtrage de mode et une polarisation linéaire dans le guide solide de lumière 107, et est partagée en deux faisceaux lumineux à polarisation linéaire qui ressortent chacun par un port d'entrée-sortie de dérivation 105, 106. Ces deux faisceaux lumineux parcourent en sens opposés la fibre optique 200 constituant l'anneau interférométrique et en ressortent avec un certain déphasage relatif pour pénétrer à nouveau dans le circuit en optique intégrée 102 par les ports d'entrée-sortie de dérivation, être réunis et subir un filtrage de mode. Ils retournent ensuite à la diode laser qu'ils traversent et viennent frapper le photodétecteur 103 mélangés à l'onde lumineuse directement émise par la face arrière de la diode laser.

La puissance optique P résultant de la recombinaison des deux faisceaux lumineux de puissances optiques respectives P1 et P2 qui ont parcouru en sens inverses la fibre optique constituant l'anneau interférométrique s'exprime par :

$$P \ = \ P1 + P2 + 2 \ \sqrt{P1 \ P2} \cos \Delta \phi$$

$\Delta\phi$ étant le déphasage relatif du à l'effet Sagnac ou à l'effet Faraday sur les deux faisceaux lorsqu'ils parcourent la fibre optique 200 en sens opposés.

Elle présente une composante utile proportionnelle au $\cos \Delta\phi$ ayant l'inconvénient d'aboutir à une sensibilité nulle pour les petits déphasages.

Pour améliorer cette sensibilité, il est connu de moduler l'angle de phase des deux faisceaux contrapropagatifs parcourant l'anneau interférométrique de manière à obtenir des écarts de phase instantanés égaux mais de signes opposés sur les deux faisceaux. Cette modulation de phase s'obtient par effet électro-optique en créant entre les paires d'électrodes 111, 112, 113, 114 un champ électrique pulsé à la demi-fréquence de résonance de l'anneau de l'interféromètre dite fréquence propre de l'interféromètre. L'ajout de cette modulation de phase a pour effet de tranformer l'expression de la puissance lumineuse P des deux faisceaux lumineux de retour de l'anneau interférométrique de la manière suivante :

$$P \ = \ P1 + P2 + \sqrt{P1. \ P2} \cos \left[ \Delta\phi + \alpha \cos \ \frac{2\pi}{2\tau} t + \beta \right]$$

$\alpha$ étant un indice de modulation et $\tau$ le temps de parcours de l'anneau interférométrique par un faisceaux lumineux.

Cette puissance lumineuse présente un spectre de fréquence riche en composantes avec notamment :
— une composante continue,

— une composante à la fréquence 1/2τ de la modulation de phase, proportionnelle au sinus du déphasage relatif Δφ donnant un maximum de sensibilité dans la plage des petits déphasages relatifs,

— une composante au double 1/τ de la fréquence de modulation de phase, qui est proportionnelle au cosinus du déphasage relatif Δφ et s'annule avec ce dernier.

Dans les montages optiques où la diode laser et le photodétecteur ne sont pas alignés mais montés à l'aide d'un coupleur directif, le déphasage relatif des deux faisceaux lumineux de retour de l'anneau interférométrique est mesuré à partir d'une composante à la fréquence 1/2τ extraite du signal du photodétecteur par une démodulation synchrone.

Lorsque la diode laser et le photo-détecteur sont alignés ou constitués du même élément, il est habituel de faire émettre par la diode laser des impulsions lumineuses périodiques de durée inférieure à leur temps de retour et de détecter la puissance optique du retour d'impulsion soit à l'aide de la diode laser transformée en photodétecteur entre l'émission de deux impulsions lumineuses soit à l'aide d'un photodétecteur recevant le retour d'impulsion traversant la diode laser de sa face avant à sa face arrière.

Pour avoir un bon rendement énergétique, on est conduit à adopter des durées d'émission d'impulsion lumineuse et de retour d'impulsion lumineuse maximales τ' qui correspondent au double du temps de parcours τ″ mis par la lumière pour aller de la diode laser à l'anneau interférométrique augmenté du temps de parcours τ dans l'anneau interférométrique

$$\tau' = 2\tau'' + \tau$$

Il en résulte une période de commutation émission-réception double 2τ' très proche de la période de modulation de phase 2τ dans la mesure où la distance entre la diode laser et l'anneau interférométrique est très inférieure à la longueur de cet anneau de sorte que l'on retrouve dans le spectre du signal engendré par le photodétecteur, au voisinage de la fréquence 1/2τ, des raies provoquées par la modulation due à la commutation émission-réception de la diode laser qui perturbent la détection de la raie utile à 1/2τ engendrée par la modulation de phase.

Pour éliminer cette perturbation il est connu d'éloigner la fréquence de commutation émission-réception de la diode laser de la fréquence de modulation de phase en prolongeant le trajet de l'impulsion lumineuse entre la diode laser et l'anneau interférométrique en intercalant sur ce trajet une longueur auxiliaire de fibre optique monomode de l'ordre du quart de la longueur de la fibre optique 200 constituant l'anneau interférométrique mais cela à l'inconvénient d'augmenter l'encombrement du dispositif et de diminuer le rendement énergétique lumineux.

Selon la solution de l'invention, on propose d'isoler un signal utile dans une autre raie du signal issu du photodétecteur à la suite de la combinaison de la modulation de phase et de la modulation résultant de la commutation émission-réception de la diode laser ou plus généralement d'une modulation de l'amplitude de l'énergie lumineuse émise par la diode laser.

En effet, une modulation sinuoïdale à la fréquence f1 de l'amplitude de l'énergie lumineuse émise par la diode laser se traduit sur l'énergie de chacun des deux faisceaux lumineux entrant dans l'anneau interférométrique par une loi de variation de la forme :

$$P1 = P01 \, (1 + m \sin 2\pi f 1t)$$

$$P2 = P02 \, (1 + m \sin 2\pi f 1t)$$

P01 et P02 étant des constantes et m un taux de modulation d'amplitude, de sorte que la puissance des deux faisceaux lumineux de retour de l'anneau interférométrique répond, compte tenu de la modulation de phase à une relation de la forme :

$$P = (1 + m.\sin 2\pi f1t) \left[ P01 + P02 + 2\sqrt{P01.\,P02} \cos \left( \Delta\phi + \cos \frac{\pi}{\tau} t + \beta \right) \right]$$

L'analyse mathématique de cette relation au moyen des fonctions de Bessel montre que la puissance optique P des faisceaux issus de l'anneau interférométrique possède un spectre de fréquence très riche en harmoniques avec une raie à la fréquence $|\frac{1}{2\tau} - f1|$ dont la puissance P' est proportionnelle au sinus de leur angle de déphasage relatif conformément à la relation :

4

$$P' = \frac{1}{2} m Po\, J_1\,(\alpha)\, \sin \Delta \phi\, \sin \left(2\pi \left|\frac{1}{2\tau} - f1\right| t + \beta\right)$$

(J1 étant une fonction de Bessel de première espèce d'ordre 1 et Po la somme des puissances lumineuses Po1 et Po2).

Cette composante qui existe pour peu que les deux fréquences de modulation soit légèrement différentes, peut servir pour la mesure du déphasage relatif des deux faisceaux avec une sensibilité maximale pour les petits déphasages.

La platine d'électronique 300 permet de mettre en oeuvre les deux modulations d'amplitude et de phase pour engendrer cette composante, de l'isoler et de l'exploiter pour en tirer la valeur du déphasage relatif entre les deux faisceaux de retour de l'anneau interférométrique. Elle peut se décomposer en une partie émission engendrant les signaux électriques nécessaires à la double modulation d'amplitude et de phase des deux faisceaux lumineux contrapropagatifs parcourant l'anneau interférométrique, en une partie réception extrayant du battement des deux faisceaux contrapropagatifs de retour de l'anneau interférométrique un signal proportionnel à leur déphasage relatif, en une partie d'exploitation numérique du signal de la partie réception assurant également la transmission de la mesure vers l'extérieur du système interférométrique ainsi qu'une synchronisation éventuelle de cette mesure avec une référence temporelle externe, et en une partie de service comprenant une alimentation électrique 301 et une régulation thermique de la platine optique 100.

La régulation thermique de la platine optique 100 est assurée par un bloc de régulation 302 couplé des éléments de mesure de température 115 de la platine optique 100.

La partie émission comporte un modulateur 303 de la puissance optique de la diode laser 101 et un générateur synthétiseur de fréquence 304.

Le modulateur de puissance 303 est stabilisé par une boucle de contre-réaction incluant le photodétecteur 103 couplé à la face arrière de la diode laser 101. Il est pourvu d'une entrée de porteuse de modulation f1 contrôlée par une sortie du synthétiseur de fréquence 304. Ce synthétiseur de fréquence 304 pilote par une deuxième sortie sur laquelle il délivre une fréquence f2 égale $1/2\tau$, les paires d'électrodes 111, 112, 113, 114 des modulateurs optiques de phase du circuit en optique intégrée 102 et, par une troisième sortie sur laquelle il délivre une fréquence |f1 − f2| un circuit de démodulation synchrone 305 de la partie réception. Il présente également une entrée de synchronisation commandée par un circuit d'horloge 306 de la partie d'exploitation numérique du signal reçu.

La partie réception comporte le circuit de démodulation synchrone 305 précédé d'un circuit d'amplification et de filtrage 307 relié à la sortie du photodétecteur 103 couplé à la face arrière de la diode laser 101 et suivi d'un autre circuit d'amplification et de filtrage 308.

Le photodétecteur 103 couplé à la face arrière de la diode laser 101 délivre un signal proportionnel à la puissance lumineuse qu'il reçoit de la diode laser soit directement soit après passage dans l'anneau interférométrique et traversée en retour de la diode laser. Ce signal comporte :

— une composante principale à la fréquence f1 de modulation de la puissance lumineuse émise par la diode due au flux lumineux reçu directement de la diode laser par sa face arrière,

— et une composante d'amplitude beaucoup plus faible provenant du battement des deux faisceaux lumineux contrapropagatifs qui sont modulés à la fois en amplitude et en phase et qui ont traversé la diode laser à leur retour de l'anneau interférométrique, cette composante vérifiant comme on l'a vu précédemment, une relation de la forme.

$$P = (1 + m\, \sin 2\pi f1 t)\left[ Po1 + Po2 + 2\sqrt{Po1.Po2}\, \cos\left(\Delta \phi + \cos\left(\frac{\pi}{\tau} t + \beta\right)\right)\right]$$

Il est filtré et amplifié par le circuit 307 pour en tirer une composante à la fréquence |f1 − f2| qui est, comme mentionné précédemment de la forme :

$$P' = \frac{1}{2} m Po\, J_1\,(\alpha)\, \sin \Delta \phi\, \sin \left(2\pi |f1 - f2| t + \beta\right)$$

et qui, appliquée au démodulateur synchrone 305 puis filtrée et amplifiée par le circuit 77 donne naissance à un signal de mesure de déphasage relatif de la forme :

$$s(t) = k \sin \Delta\phi(t)$$

Cette technique permet d'utiliser une fréquence de modulation d'amplitude f1 proche de celle f2 de la modulation de phase. Dans le cas d'un gyromètre où l'on utilise pour l'anneau interférométrique une fibre optique monomode à maintien de polarisation de l'ordre du kilomètre, la fréquence propre de l'interféromètre et donc de la modulation de phase est de l'ordre de 100 KHz et l'on peut envisager une fréquence de modulation d'amplitude de l'énergie lumineuse de la diode laser proche, de l'ordre de 98 KHz. Cela permet, si l'on désire employer une modulation d'amplitude par tout ou rien pour séparer sur le photodétecteur l'impulsion émise et son retour, de n'avoir à rallonger que très faiblement les trajets des faisceaux lumineux sur leur parcours entre la diode laser et l'anneau interférométrique, ce rallongement étant dans l'exemple précité de l'ordre de 10 mètres de fibre au lieu des 250 dans la solution antérieure.

De même dans le cas d'un appareil de mesure de courant par effet Faraday où l'anneau interférométrique est une fibre optique monomode à très forte biréfringence circulaire d'une dizaine de mètres de long donnant lieu à une fréquence propre de l'interféromètre donc de la modulation de phase de l'ordre de 10 MHz on peut envisager une fréquence de modulation d'amplitude de l'énergie lumineuse du laser de l'ordre de 9,95 MHz. Cela permet dans les conditions d'une modulation d'amplitude par tout ou rien de la diode laser pour séparer l'impulsion émise et son retour au niveau du photodétecteur de n'avoir à rallonger le parcours du faisceau lumineux entre la diode laser et l'anneau interférométrique d'une longueur de fibre de l'ordre de 25 cm au lieu des 2,5 mètres de la solution antérieure.

Le signal de mesure de déphasage relatif s(t) disponible en sortie du circuit amplificateur 308 est échantillonné et numérisé par un convertisseur analogique-numérique 309 qui comporte un échantillonneur-bloqueur et un dispositif de conversion analogique-numérique fonctionnant selon les techniques habituelles.

La partie d'exploitation numérique du signal de la platine électronique 300 comporte un processeur de traitement 310, un processeur de communication 311 et le circuit d'horloge 306.

Le processeur de traitement 310 a pour rôle principal d'extraire du signal s(t) de la partie réception, disponible sous forme numérique en sortie du convertisseur analogique-numérique 309, une valeur explicite du déphasage relatif des deux faisceaux lumineux contrapropagatifs issus de l'anneau interférométrique et d'en déduire soit une valeur de vitesse angulaire en cas de gyrométrie soit une valeur d'intensité de courant en cas de mesure de courant par effet Faraday en exploitant les relations de définition de l'effet Sagnac ou de l'effet Faraday.

Le processeur de communication 311 assure le codage, la sérialisation et la transmission numérique du résultat de la mesure instantanée délivré par le processeur de traitement 310, la transmission se faisant vers l'extérieur au moyen d'une diode électroluminescente 312 et d'une fibre optique monomode ou multimode 313.

Le circuit d'horloge 306 reçoit une synchronisation externe par l'intermédiaire d'une autre fibre optique monomode ou multimode 314 utile dans le cas où le système interférométrique doit fonctionner en synchronisme avec d'autres appareillages. Il délivre également un signal d'horloge stable utilisé par le générateur synthétiseur de fréquence 304 de la partie émission pour élaborer les porteuses de modulation f1, f2 ainsi que la porteuse de démodulation (f1-f2) convenablement déphasée pour assurer un fonctionnement correct du circuit de démodulation synchrone 305.

## Revendications

1. Système interférométrique à fibre optique de type Sagnac comportant :
— une fibre optique (200) formant une boucle interférométrique,
— une source lumineuse (101) et un photodétecteur (103) colinéaires,
— des moyens de couplage optique (102) permettant de diviser l'onde lumineuse émise par la source (101) en deux faisceaux chacun appliqué à une extrémité de ladite fibre optique (200) et de recombiner les deux faisceaux émergeant des deux extrémités de ladite fibre optique (200) en une onde lumineuse colinéaire avec celle émise par la source (101) mais de sens opposé et dirigée vers le photodétecteur (103),
— des moyens de modulation de phase (111, 112, 113, 114) imposant aux deux faisceaux circulant dans ladite fibre optique (200) une modulation de phase périodique et symétrique,
— des moyens de modulation d'amplitude (303) agissant sur la puissance d'émission de la source lumineuse (101),
— des moyens électroniques de traitement du signal du photodétecteur (103), caractérisé en ce que lesdits moyens électroniques de traitement du signal du photodétecteur (103) comportent un démodulateur (305) opérant à la fréquence du battement inférieur de la fréquence de modulation de phase des faisceaux et de la fréquence de modulation d'amplitude de la source lumineuse (101).

2. Système interférométrique selon la revendication 1, caractérisé en ce que le démodulateur (305) est un démodulateur synchrone.

3. Système interférométrique selon la revendication 1, caractérisé en ce que la modulation d'amplitude est une modulation par tout ou rien permettant de faire fonctionner la source lumineuse (101) en impulsions.

## Patentansprüche

1. Interferometrisches faseroptisches System vom Sagnactyp mit :
— einer Lichtleitfaser (200), die eine interferometrische Schleife bildet,
— einer Lichtquelle (101) und einem dazu kolinearen Lichtdetektor (103),
— optischen Kopplungsmittel (102), die die Teilung der von der Lichtquelle (101) ausgesandten Lichtwelle in zwei Strahlenbündel, die je auf ein Ende der Lichtleitfaser (200) gerichtet sind, sowie die die Wiedervereinigung der aus den beiden Enden der Lichtleitfaser (200) austretendenden Strahlenbündel zu einer Lichtwelle ermöglichen, die kolinear mit der von der Lichtquelle (101) ausgesandten Lichtwelle verläuft, jedoch in entgegengesetzter Richtung und zum Lichtdetektor (103) hin,
— Phasenmodulationsmitteln (111, 112, 113, 114), die den beiden die Lichtleitfaser (200) durchlaufenden Strahlenbündeln eine periodische und symmetrische Phasenmodulation aufprägen,
— Amplitudenmodulationsmitteln (303), die die Emissionsleistung der Lichtquelle (101) modulieren,
— elektronischen Mittel zur Behandlung des Signals des Lichtdetektors (103), dadurch gekennzeichnet, daß die elektronischen Behandlungsmittel für das Signal des Lichtdetektors (103) einen Demodulator (305) aufweisen, der mit der unteren Überlagerungsfrequenz aus der Phasenmodulationsfrequenz der Strahlenbündel und der Amplitudenmodulationsfrequenz der Lichtquelle (101) arbeitet.

2. Interferometrisches System nach Anspruch 1, dadurch gekennzeichnet, daß der Demodulator (305) ein Synchrondemodulator ist.

3. Interferometrisches System nach Anspruch 1, dadurch gekennzeichnet, daß die Amplitudenmodulation eine Ein-Aus-Modulation ist, die den Impulsbetrieb der Lichtquelle (101) ermöglicht.

## Claims

1. A Sagnac type optical fiber interferometer system comprising :
— an optical fiber (200) constituting an interferometer loop ;
— a light source (101) and a photodetector (103) which are colinear ;
— optical coupling means (102) for dividing the light wave emitted by the source (101) into two beams, each of which is applied to a respective end of said optical fiber (200), and for recombining the two beams emmerging from the two ends of said optical fiber (200) into a light wave which is colinear with the light wave emitted by the source (101) but propagating in the opposite direction and directed towards the photodetector (103) ;
— phase modulation means (111, 112, 113, 114) imparting periodic and symmetrical phase modulation to the two beams travelling along said optical fiber (200) ;
— amplitude modulation means (303) acting on the power emitted by the light source (101) ; and
— electronic means for processing the signal from the photodetector (103) ; the system being characterized in that said electronic means for processing the signal from the photodetector (103) includes a demodulator (305) operating at the lower beat frequency between the frequency of beam phase modulation and the frequency of light source amplitude modulation.

2. An interferometer system according to claim 1, characterized in that the demodulator (305) is a synchronous demodulator.

3. An interferometer system according to claim 1, characterized in that the amplitude modulation is on/off modulation serving to pulse the operation of the light source (101).